# EUROPEAN PATENT APPLICATION

(11) **EP 1 914 829 A1**
(43) Date of publication of application: **23.04.2008**
(21) Application number: 07115433.0
(22) Date of filing: 31.08.2007
(51) Int. Cl.: H01Q 1/24, H04B 1/18, H03H 7/01, H03H 7/38, H01Q 9/02

(54) **Active antenna capable of wireless signal transmission and reception and mobile communication terminal having the same**

(30) Priority: 19.10.2006 KR 20060101898
(71) Applicant: Samsung Electronics Co., Ltd, Suwon-si, Gyeonggi-do 443-742 (KR); Samsung Electro-Mechanics Co., Ltd., Yeongtong-gu Suwon-si Gyeonggi-do (KR)
(72) Inventor: Park, Se-hyun, 302-1504, Dongsuwon 3rd Ssangyong Sweet.home, Gyeonggi-do (KR); Yoon, Byung-tae, 102-1204, Ilsin Human Ville Apt., Gyeonggi-do (KR); Kim, Young-eil, 305-1803, Cheongmyeong-maeul, Suwon-si, Gyeonggi-do (KR); Yoon, Ick-jae, Seocho-gu, Seoul (KR); Balzovsky, Evgeny V., c/o Institute of High Current Electronics, 634055 Tomsk (RU); Buyanov, Yuri I., c/o Institute of High Current Electronics, 634055 Tomsk (RU); Koshelev, Vladimir I., c/o Institute of High Current Electronics, 634055 Tomsk (RU)
(74) Representative: Ertl, Nicholas Justin

(57) **Abstract**

An active antenna capable of transmitting and receiving a wireless signal of a low frequency band and a mobile communication terminal having the active antenna, are provided. The active antenna includes an antenna element (10) which transmits and receives a wireless signal, a filter (20) which filters the wireless signal being received at the antenna element such that a wireless signal belonging to a frequency band lower than the operating frequency of the antenna element is passed, and an amplifier (30) which amplifies the wireless signal being passed through the filter. As a result, the size of the antenna can be greatly reduced, by the use of an active antenna which receives wireless signals of low frequency bands. Additionally, a more compact mobile communication terminal can be provided, because wireless signal of both high frequency bands and low frequency bands can be transmitted and received at one antenna.

## Description

### BACKGROUND OF THE INVENTION

Apparatuses consistent with the present invention generally relate to wireless signal transmission and reception in low frequency bands using an active antenna and a mobile communication terminal having the active antenna, and more particularly, to the transmission and reception of wireless signals in low frequency bands using an active antenna, which provides a reduced antenna size and a compact-sized mobile communication terminal.

A wide variety of services are now available through mobile communication terminals, due to the advancement of mobile communications technologies.

The Digital Multimedia Broadcasting (DMB) or Digital Video Broadcasting-Handhelds (DVB-H) services, which receive VHF band broadcast signals and provide services, are gaining wide attention.

DMB or DVB-H is a new concept of mobile multimedia broadcasting services which combines communications and broadcasting. The low frequency band of DMB or DVB-H services can be used through a mobile communication terminal. More specifically, the DMB service is generally classified into satellite DMB and terrestrial DMB services. The terrestrial DMB service in South Korea, for example, uses a frequency band of 174-216MHz, and the satellite DMB service uses an S-band of 2.630-2.655GHz, which is higher than the terrestrial DMB.

The Digital Video Broadcasting-Handhelds (DVB-H) service is provided based on the Digital Video Broadcasting-Terrestrial (DVB-T), the Europe-oriented digital TV broadcast standard. The DVB-H service uses a frequency band ranging from 400MHz - 800MHz.

The DMB services use antennas, such as a dipole antenna with a length of λ/2 or a monopole antenna with a length of λ/4. The length of the antenna decreases as the frequency band increases, and increases as the frequency band decreases. Because the terrestrial DMB service or the DVB-H service uses VHF, which is the general broadcast band, the antenna needs to have a longer length than that used in the satellite DMB. More specifically, the antenna of the terrestrial DMB system should have the same length as the TV antenna, or greater than 30cm.

However, the terrestrial DMB has a relatively weak output which ranges between 1-2KW, because it uses taboo channels 8, 10 and 12. Channel 8 is highly likely to have interferences with channels 7 and 9 if the output is increased. However, it will be very inconvenient if the length of the antenna is prolonged in a mobile communication terminal which has to have portability and mobility.

It is therefore very important that the antenna developers decrease the length of the antenna of the terrestrial DMB, without compromising the receptivity of the antenna. Currently, it is almost impossible for the antenna of the terrestrial DMB to operate in a length below 15cm.

A mobile communication terminal also needs an antenna for mobile communication, to transmit and receive wireless signals. At the initial stage of the DMB and DVB-H services, an antenna for mobile communication and an antenna for DMB and DVB-H services were separately installed. Accordingly, the size of the mobile communication terminal increased, which is against the customer's demands for more compact terminals.

Therefore, it is necessary to provide a compact antenna which is capable of transmitting and receiving wireless signals for mobile communication and signal for DMB and DVB-H services.

An active antenna has recently gained attention as the core technology to provide miniaturization, light-weight and high-quality antennas which can keep up with the commercialization of mobile communication services and satellite communication services. An active antenna is generally constructed by directly coupling an amplifier such as a Low Noise Amplifier (LNA) to the antenna.

In the early stage of active antennas, the antenna element and the amplifier operated as independent elements, which resulted in an increase of the overall size of the antenna. Additionally, the requirement for a matching circuit to match the antenna element with the amplifier impeded integration and efficiency of the antenna. Active antennas of higher efficiency and greater compactness were later proposed, which removed the need for a harmonic tuning circuit by regulating harmonic components generated from the amplifier.

Accordingly, the size of the antenna could be decreased and the mobile communication terminal could also be made more compact, if an antenna for DMB and DVB-H services is constructed by incorporating the active antenna.

### SUMMARY OF THE INVENTION

According to an aspect of the present invention, there is provided an active antenna capable of transmitting and receiving a wireless signal of a low frequency band, comprising: an antenna element which transmits and receives a wireless signal, a filter which filters the wireless signal being received at the antenna element such that a wireless signal belonging to a frequency band lower than the operating frequency of the antenna element is passed, and an amplifier which amplifies the wireless signal being passed through the filter.

The present invention aims to overcome the above disadvantages and other disadvantages not described above. Also, the present invention is not required to overcome the disadvantages described above, and an exemplary embodiment of the present invention may not overcome any of the problems described above.

The present invention provides an active antenna, which is compact-sized to reduce the size of a mobile communication terminal incorporating the same, and is capable of transmitting and receiving a wireless signal in low frequency band, and a mobile communication terminal having the active antenna.

The filter may comprise a band pass filter (BPF), and the BPF may comprise a high pass filter (HPF) which comprises a plurality of capacitors. The BPF may also comprise a low pass filter (LPF) which comprises a plurality of capacitors.

The BPF may operate as a matching circuit such that the operating frequency of the antenna element is matched with a frequency band which is lower than the operating frequency of the antenna element.

The amplifier may comprise a low noise amplifier (LNA).

The antenna element may be sized to be suitable for transmitting and receiving a wireless signal of a frequency band which is higher than a frequency band which is lower than the operating frequency of the antenna element.

According to another aspect of the present invention, there is provided a mobile communication terminal comprising an active antenna, the active antenna comprising an antenna element which transmits and receives a wireless signal, a filter which filters the wireless signal being received at the antenna element such that a wireless signal belonging to a frequency band lower than the operating frequency of the antenna element is passed, and an amplifier which amplifies the wireless signal being passed through the filter, a low frequency circuit which processes a wireless signal of a low frequency band being received at the active antenna, a high frequency circuit which processes a wireless signal of an operating frequency band being transmitted and received at the antenna element, and a selective connecting unit which selectively connects the antenna element with one of the high frequency circuit and the low frequency circuit.

The low frequency circuit may process at least one of a wireless signal for Digital Multimedia Broadcasting (DMB) service, and a wireless signal for Digital Video Broadcasting-Handhelds (DVB-H) service to a form suitable for output.

The high frequency circuit may process at least one of a wireless signal for mobile communication, a wireless signal for radio frequency identification (RFID), a wireless signal for global system for mobile communication (GSM), a wireless signal for Wireless LAN (WLAN), a wireless signal for Wireless Broadband Internet (WiBro), and a wireless signal for Bluetooth communication to a form suitable for output.

The low frequency circuit may be coupled to the amplifier of the active antenna, and the high frequency circuit may be coupled to the antenna element.

The selective connecting unit may be interposed between the antenna element and the filter, and connect the antenna element with one of the filter and the high frequency circuit.

The selective connecting unit may comprise at least one of a power divider, a directional coupler, a diplexer, and a switch.

The filter may comprise a variable band pass filter (BPF) which is capable of varying filtering band.

### BRIEF DESCRIPTION OF THE DRAWING FIGURES

These and other aspects of the present invention will become more apparent and more readily appreciated from the following description of exemplary embodiments thereof, with reference to the accompanying drawings, in which:
FIG. 1 is a block diagram of an active antenna according to an exemplary embodiment of the present invention;
FIG. 2 is a circuit diagram of the active antenna of FIG. 1;
FIG. 3A is a plan view illustrating an external monopole antenna to be used as an antenna element of FIG. 1;
FIG. 3B is a graphical representation of a resonance frequency of the monopole antenna of FIG. 3A;
FIG. 4A is a plan view illustrating an internal patch antenna to be used as the antenna element of FIG. 1;
FIG. 4B is a graphical representation of a resonance frequency of the patch antenna of FIG. 4A;
FIG. 5 is a graphical representation illustrating the measurement of wireless signal being output from a Low noise Amplifier (LNA) when the LNA has the BPF of FIG. 2 mounted thereon (BPF present), and when the LNA does not have the BPF of FIG. 2 mounted thereon (BPF absent); and
FIGS. 6 to 9 are circuit diagrams illustrating a mobile communication terminal incorporating the active antenna according to an exemplary embodiment of the present invention.

### DETAILED DESCRIPTION OF EXEMPLARY EMBODIMENTS OF THE PRESENT INVENTION

Certain exemplary embodiments of the present invention will now be described in greater detail with reference to the accompanying drawings.

In the following description, the same drawing reference numerals are used to refer to the same elements, even in different drawings. The matters defined in the following description, such as detailed construction and element descriptions, are provided as examples to assist in a comprehensive understanding of the invention. Also, well-known functions or constructions are not described in detail, since they would obscure the invention in unnecessary detail.

Also in the following description, the active antenna and the mobile communication terminal may be configured to handle the transmission and processing of wireless signals of a low frequency band, such as a terrestrial DMB service or a DVB-H service. Also in the later part of the description, the 'DMB' may refer to terrestrial DMB.

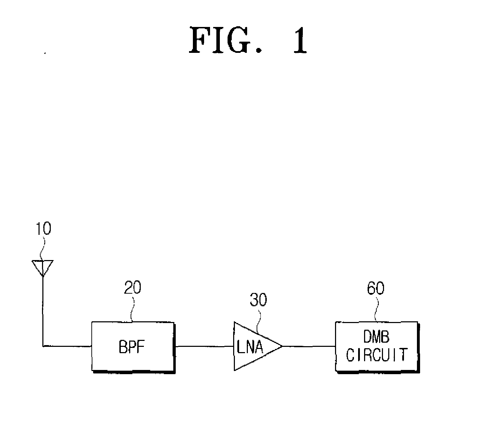

FIG. 1 is a block diagram of an active antenna according to an exemplary embodiment of the present invention.

The active antenna may include an antenna element 10, a band pass filter (BPF) 20, and a low noise amplifier (LNA) 30. A wireless signal which is sent from the LNA 30 is provided to a DMB processing circuit 60. Although FIG. 1 illustrates LNA 30 coupled only with the DMB processing circuit 60, one will understand that the LNA 30 may be coupled to a variety of circuits such as a DVB-H processing circuit, circuits which process low frequency band wireless signals, or the like.

The antenna element 10 may be mounted externally or internally, and sized so that it would not resonate with the low frequency band for the terrestrial DMB service or the DVB-H service, but would resonate with a high frequency band, i.e., a frequency band that is several hundred times higher than the low frequency band, such as the frequency band for the transmission and reception of mobile communication signals or the transmission and reception of RFID signals. The configurations, sizes and resonance frequencies of the antenna element 10 will be explained in greater detail below.

The BPF 20 filters a wireless signal being received at the antenna element 10 such that only a signal of a predetermined frequency band, such as a DMB service band or a DVB-H service band can pass. Additionally, the BPF 20 operates as a matching circuit between the antenna element 10 and the LNA 30. Accordingly, it is not necessary to install a separate matching circuit because the antenna element 10, which is sized to transmit and receive mobile communication signals, is capable of receiving wireless signals of terrestrial DMB services or DVB-H services based on the matching operation of the BPF 20.

The LNA 30 operates to amplify the wireless signal being passed through the BPF 20, and also minimize any noise in the wireless signal.

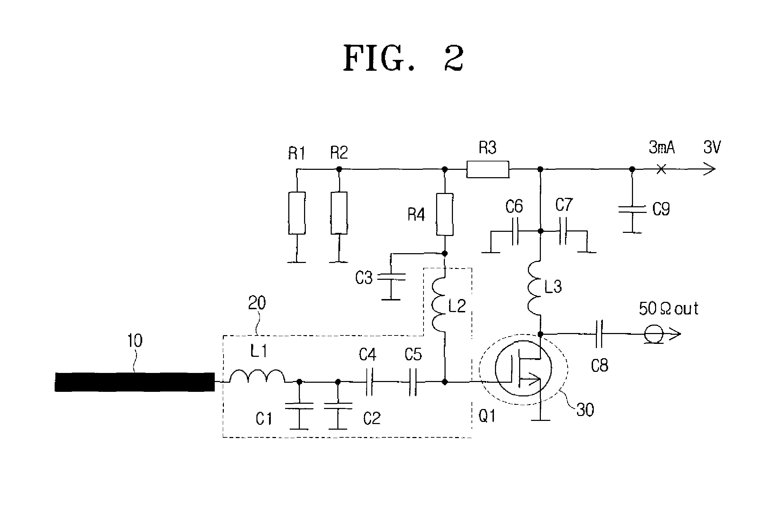

FIG. 2 is a circuit diagram of the active antenna of FIG. 1.

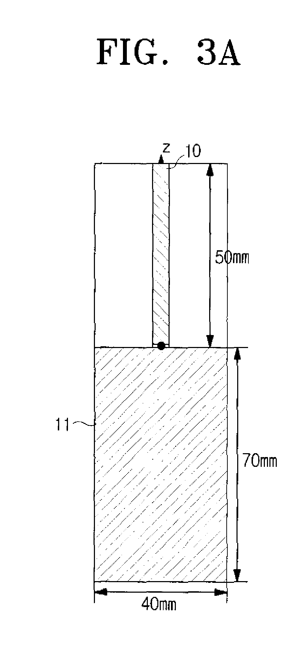

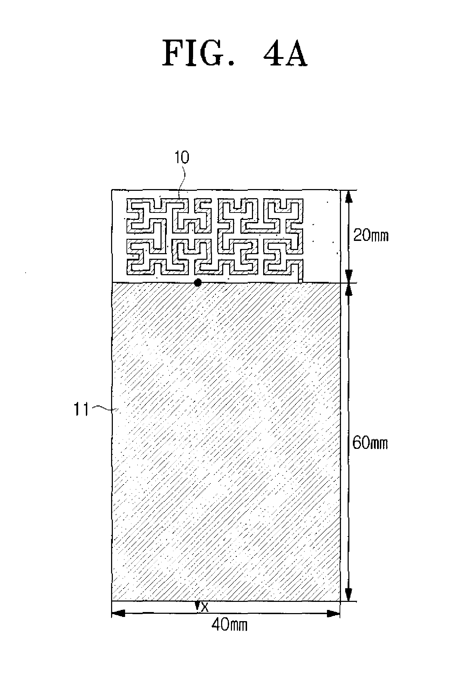

Referring to FIG. 2, the antenna element 10 is represented in a bar configuration. However, one will understand that the antenna element 10 may be configured such that it can be mounted internally, or externally as illustrated in FIG. 3A or FIG. 4A.

The BPF 20 may include a low pass filter (LPF) and a high pass filter (HPF), such that the arrangement of the LPF and HPF in sequence filters the wireless signal. The LPF may include a first inductor L1, and first and second capacitors C1 and C2, and the HPF may include a second inductor L2, and third and fourth capacitors C4 and C5. The first inductor L1 and the third and fourth capacitors C4 and C5 may be coupled in series, and the first and second capacitors C 1 and C2 may be arranged on a line which is branched off from the line between the first inductor L1 and the third capacitor C4. The first and second capacitors C1 and C2 may be arranged in parallel relation. The second inductor L2 may be arranged on a line which is branched off from a line between the fourth capacitor C5 and the LNA 30.

The LNA 30 may implement a Field Effect Transistor (FET).

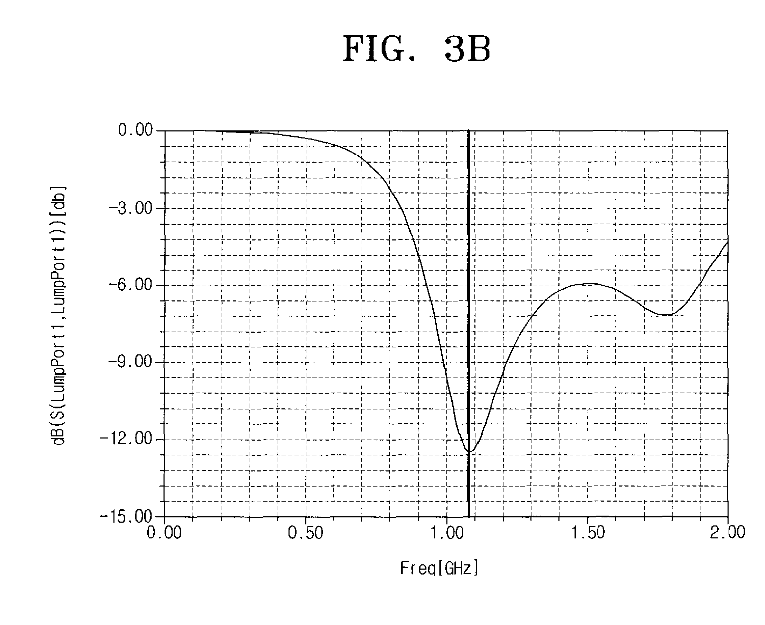

FIG. 3A is a plan view illustrating an external monopole antenna to be used as an antenna element of FIG. 1, and FIG. 3B is a graphical representation of a resonance frequency of the monopole antenna of FIG. 3A.

As shown in FIGS. 3A and 3B, a monopole antenna having a 70mm*40mm ground 11, and a 50mm-length antenna element 10 has an operation frequency at a frequency band of 1.0GHz. Accordingly, the external antenna element 10 as shown in FIG. 3A resonates at a frequency band which is approximately five times higher than the frequency band of a terrestrial DMB service, which is 174MHz - 216MHz.

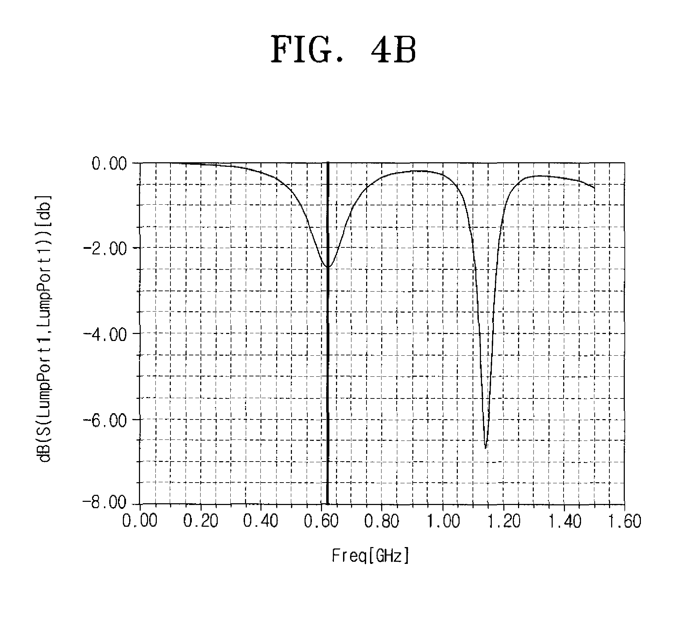

FIG. 4A is a plan view illustrating an internal patch antenna to be used as the antenna element of FIG. 1, and FIG. 4B is a graphical representation of a resonance frequency of the patch antenna of FIG. 4A.

As shown in FIGS. 4A and 4B, the internal patch antenna includes a 60mm*40mm ground11, a 20mm-wide antenna element 10, and has double resonance frequencies, which are 600MHz and 1.8GHz. Accordingly, the patch antenna resonates at a frequency band which is approximately three times higher than the frequency band of a terrestrial DMB service.

As explained above, the antenna element 10 is sized to accommodate the transmission and reception of mobile communication signals or RFID signals, rather than the terrestrial DMB service or the DVB-H service. Accordingly, the length of the antenna element 10 can be greatly reduced, compared to the antenna for the terrestrial DMB service or the DVB-H service. The antennas of FIGS. 3A and 4A are only for illustrative purposes, and the length of the antenna element 10 and the size of the ground 11 may be varied, and accordingly, the operating frequency of the external monopole antenna is variable. Likewise, the internal patch antenna may also have a variety of configurations and sizes.

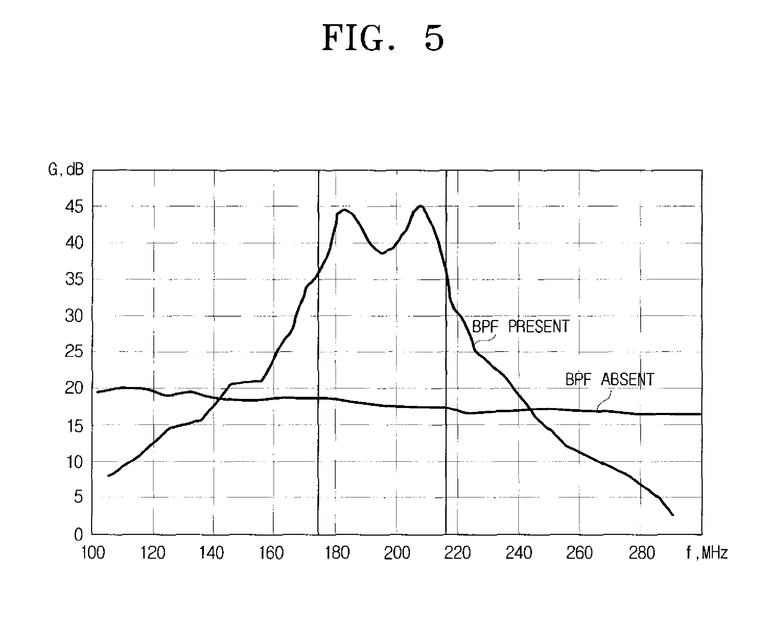

FIG. 5 is a graphical representation illustrating the measurement of wireless signals being output from a LNA when the LNA has the BPF of FIG. 2 mounted thereon (BPF present), and when the LNA does not have the BPF of FIG. 2 mounted thereon (BPF absent).

The antenna element 10 may implement the external monopole antenna of FIG. 3A, or the internal patch antenna of FIG. 4A.

As shown, the antenna element 10 and the LNA 30 are not matched, if the BPF 20 is not provided. In this case, the operating frequency of the antenna element 10 corresponds to the length of the antenna element 10, that is, the antenna element 10 has the mobile communication frequency band as its operating frequency. Accordingly, wireless signals of a low frequency band, including the DMB service band or DVB-H service band, are not received, and the wireless signal of low frequency band is only amplified at LNA 30, but the signal cannot be extracted.

If the BPF 20 is provided, the antenna element 10 and the LNA 30 are matched with each other, and the operating frequency of the antenna element 10 is determined according to the BPF 20. As a result, the antenna element 10 has the operating frequency changed to the low frequency band, and the wireless signal of low frequency band is received at the antenna element 10. The wireless signal of a low frequency band is then filtered through the BPF 20 such that the signal of a predetermined band such as a DMB service band or a DVB-H service band is passed, and amplified at the LNA 30. As a result, a wireless signal, which is approximately 20dB higher than when the BPF 20 is not provided, is output. The experimental outputs indicate that the BPF 20 operates as a filter and as a matching circuit.

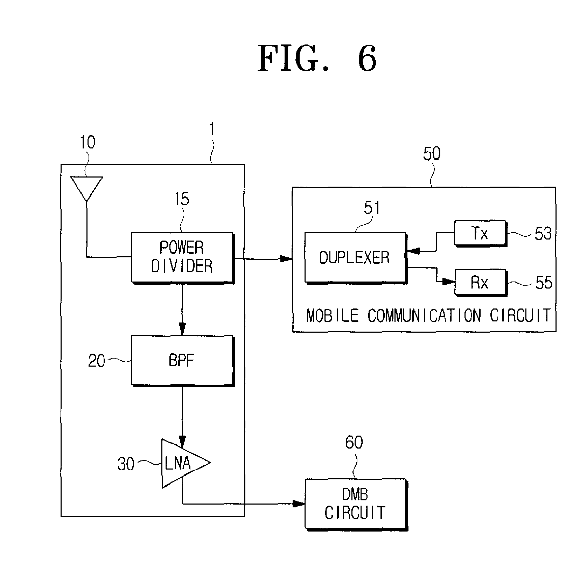

FIGS. 6 to 9 are circuit diagrams of a mobile communication terminal having the active antenna according to an exemplary embodiment of the present invention.

Referring to FIG. 6, the active antenna 1 may include a power divider 15 between the antenna element 10 and the BPF 20, which operates to divide the wireless signal according to the magnitude of the power. In one exemplary implementation, the power divider 15 may divide a wireless signal being received at the antenna element 10 into a wireless signal for an 800MHz frequency of mobile communications and a wireless signal for a 200MHz band of a DMB service.

The power divider 15 may include a first output coupled to a circuit for high frequency band wireless signals, and a second output coupled to a circuit for low frequency band wireless signals. Accordingly, a wireless signal of an 800MHz band may be passed through the first output and provided to the circuit for high frequency band wireless signals, and a wireless signal of 200MHz may be passed through the second output and provided to the circuit for high frequency band wireless signals. The power divider 15 may be implemented as a directional coupler.

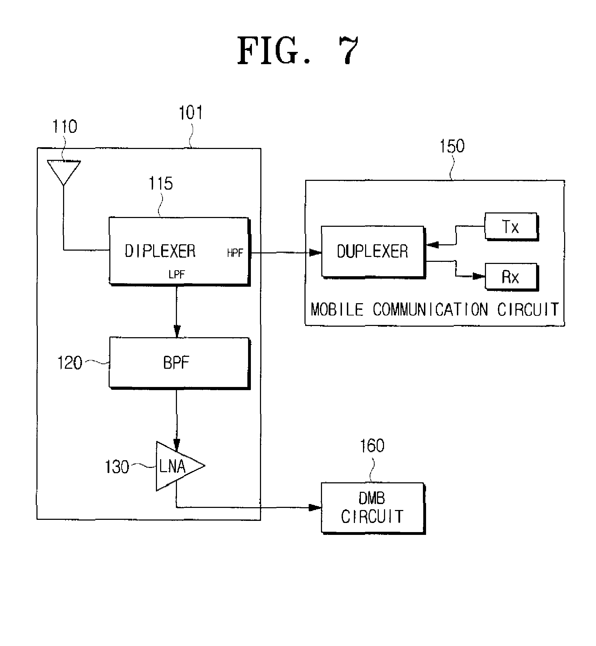

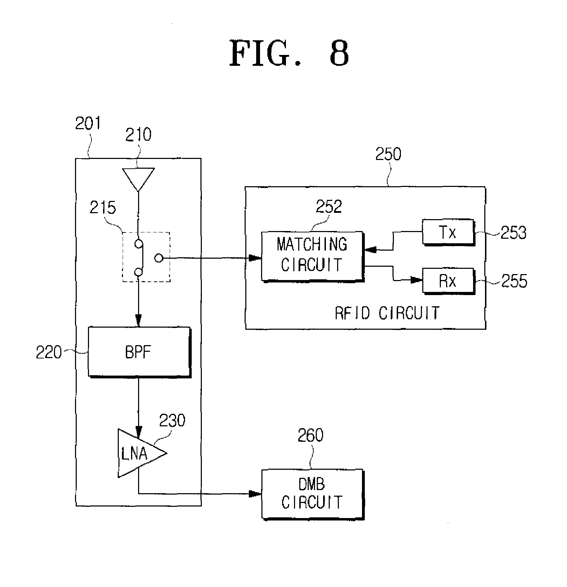

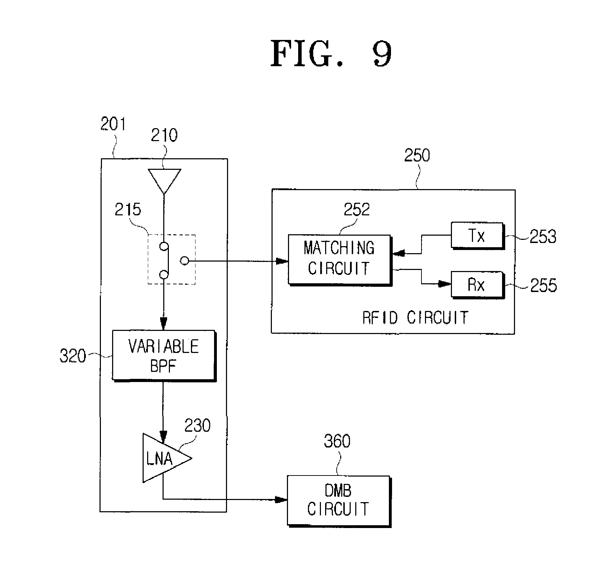

The circuit for high frequency band wireless signals may operate to process a wireless signal for one of mobile communication, radio frequency identification (RFID), global system for mobile communication (GSM), Wireless LAN (WLAN), Wireless Broadband Internet (WiBro), or Bluetooth. FIGS. 6 and 7 respectively illustrate a high-frequency band wireless signal circuit 50 and 150 which processes a wireless signal for mobile communication, and FIGS. 8 and 9 illustrate a RFID circuit 250. The circuit 50 for mobile communication may include a duplexer 51, a receiving circuit 55 and a transmitting circuit 53. The duplexer 51 may divide the signal being received at the receiving circuit 55 or output at the transmitting circuit 53, according to the frequency band.

FIGS. 6 to 9 also show a DMB circuit 60, 160, 260, and 360 respectively as the low-frequency band wireless signal circuit, which processes a wireless signal of low frequency bands such as the wireless signal of the DMB service or the DVH-B service.

When a mobile communication terminal operates in a mobile communication mode in which a wireless signal for mobile communication is transmitted and received, the BPF 20 and the LNA 30 of the active antenna 1 do not operate. Therefore, the operating frequency of the antenna element 10 operates in the mobile communication frequency band. A wireless signal in the mobile communication frequency band is transmitted and received at the antenna element 10, and the power divider 15 inputs and outputs a wireless signal at the mobile communication circuit 50, via the first output.

When the mobile communication terminal operates in a DMB mode in which a wireless signal of a DMB service is transmitted and received, the BPF 20 and the LNA 30 of the active antenna 1 operate, and the operating frequency of the antenna element 10 is converted to the DMB service frequency band by the BPF 20. As a result, a wireless signal received at the antenna element 10 is filtered through the BPF 20, amplified at the LNA 30 and provided to the DMB circuit 60.

The mobile communication terminal illustrated in FIG. 7 includes a diplexer 115, instead of the power divider 15 of FIG. 6. The diplexer 115 distributes signals according to the frequency band, and includes a LPF and a HPF. The LPF and HPF of the diplexer 115 may set their filtering bands, respectively. The LPF is coupled to the DMB circuit 160, and the HPF is coupled to the mobile communication circuit 150. If the filtering band of the LPF is set to 600MHz, for example, a wireless signal in low frequency band below 600MHz is provided to the DMB circuit 160, and if the HPF is set to 800MHz, the mobile communication circuit 150 receives a wireless signal of a high-frequency band above 800MHz.

A mobile communication terminal according to an exemplary embodiment of the present invention is constructed such that a wireless signal of a high frequency band is provided to the mobile communication circuit 150 via the HPF of the diplexer 115 in a mobile communication mode, and a wireless signal of a low frequency band is selected via the LPF of the diplexer 115 in a DMB mode and is provided to the DMB circuit 160 via the BPF 120 and the LNA 130.

FIG. 8 illustrates a mobile communication terminal as a circuit for processing a wireless signal of a high frequency band, which includes a RFID circuit 250.

The RFID circuit 250 may include a matching circuit 252 for matching the impedance of the antenna element 210 with the RFID circuit 250, a receiving circuit 255, and a transmitting circuit 253.

The mobile communication terminal according to an exemplary embodiment of the present invention may include a switch 215 interposed between the antenna element 210 and the BPF 220. The switch 215 connects the RFID circuit 250 with the antenna element 210 in a RFID mode, and connects the antenna element 210 with the BPF 220 in the DMB mode so that the active antenna 201, including the antenna element 210, the BPF 220 and the LNA 230, operates.

The mobile communication terminal of FIG. 9 is of a similar structure as the mobile communication terminal of FIG. 8, except that the mobile communication terminal of FIG. 9 employs a variable BPF 320 which varies the frequency band to filter. Accordingly, the frequency band of wireless signal being provided to the DMB circuit may be varied. Because the mobile communication terminal of FIG. 9 operates in a similar manner as the mobile communication terminal shown in FIG. 8, detailed description thereof will be omitted for the sake of brevity.

As explained above, the active antenna 1 according to an exemplary embodiment of the present invention includes a BPF 20 as a matching circuit, which matches the operating frequency of the antenna element 10 with the DMB service band or the DVB-H service band. With the use of the active antenna 1, the DMB service or the DVB-H service may be provided, using the antenna element 10 which is sized as small as the antenna of the mobile communication terminal. As a result, the size of the antenna for the DMB service or the DVB-H service can be greatly reduced.

Since the mobile communication terminal which incorporates the active antenna 1 according to the exemplary embodiment of the present invention operates the active antenna 1 during the reception of wireless signals of a low frequency band, and operates only the antenna element 10 during the transmission and reception of wireless signals of a high frequency band, the mobile communication terminal is capable of transmitting and receiving both the wireless signals of high frequency bands such as mobile communication signals and the wireless signals of low frequency band such as the DMB service signal or the DVB-H service signal, using only one antenna. Since only one antenna is implemented, the mobile communication terminal is compact-sized.

As mentioned above, according to the exemplary embodiments of the present invention, the size of the antenna can be greatly reduced, by the use of an active antenna which receives wireless signals of low frequency bands. Additionally, a more compact mobile communication terminal can be provided, because wireless signals of both high frequency bands and low frequency bands can be transmitted and received at one antenna.

Although a few exemplary embodiments of the present general inventive concept have been shown and described, it will be appreciated by those skilled in the art that changes may be made in these exemplary embodiments without departing from the scope of the invention as defined in the appended claims.

## Claims

1. An active antenna capable of transmitting and receiving a wireless signal of a low frequency band, comprising:
an antenna element which transmits and receives the wireless signal;
a filter which filters the wireless signal being received at the antenna element such that a wireless signal belonging to a frequency band lower than an operating frequency of the antenna element is passed; and
an amplifier which amplifies the wireless signal being passed through the filter.

2. The active antenna of claim 1, wherein the filter comprises a band pass filter (BPF).

3. The active antenna of claim 2, wherein the BPF comprises a high pass filter (HPF) which comprises a plurality of capacitors.

4. The active antenna of claim 2, wherein the BPF comprises a low pass filter (LPF) which comprises a plurality of capacitors.

5. The active antenna of claim 2, wherein the BPF operates as a matching circuit such that the operating frequency of the antenna element is matched with a frequency band which is lower than the operating frequency of the antenna element.

6. The active antenna of any preceding claim, wherein the amplifier comprises a low noise amplifier (LNA).

7. The active antenna of any preceding claim, wherein the antenna element is sized to be suitable for transmitting and receiving a wireless signal of a frequency band which is higher than a frequency band which is lower than the operating frequency of the antenna element.

8. A mobile communication terminal comprising an active antenna, the active antenna comprising:
an antenna element which transmits and receives a wireless signal;
a filter which filters the wireless signal being received at the antenna element such that a wireless signal belonging to a frequency band lower than an operating frequency of the antenna element is passed;
an amplifier which amplifies the wireless signal being passed through the filter;
a low frequency circuit which processes wireless signals of a low frequency band being received at the active antenna;
a high frequency circuit which processes wireless signals of an operating frequency band being transmitted and received at the antenna element; and
a selective connecting unit which selectively connects the antenna element with one of the high frequency circuit and the low frequency circuit.

9. The mobile communication terminal of claim 8, wherein the low frequency circuit processes at least one of a wireless signal for a Digital Multimedia Broadcasting (DMB) service, and a wireless signal for a Digital Video Broadcasting-Handhelds (DVB-H) service and outputs the processed signal.

10. The mobile communication terminal of claim 8 or 9, wherein the high frequency circuit processes at least one of a wireless signal for mobile communication, a wireless signal for radio frequency identification (RFID), a wireless signal for global system for mobile communication (GSM), a wireless signal for Wireless LAN (WLAN), a wireless signal for Wireless Broadband Internet (WiBro), and a wireless signal for Bluetooth communication and outputs the processed signal.

11. The mobile communication terminal of any one of claims 8 to 10, wherein the low frequency circuit is coupled to the amplifier of the active antenna, and the high frequency circuit is coupled to the antenna element.

12. The mobile communication terminal of any one of claims 8 to 11, wherein the selective connecting unit is interposed between the antenna element and the filter, and connects the antenna element with one of the filter and the high frequency circuit.

13. The mobile communication terminal of any one of claims 8 to 12, wherein the selective connecting unit comprises at least one of a power divider, a directional coupler, a diplexer, and a switch.

14. The mobile communication terminal of any one of claims 8 to 13, wherein the filter comprises a band pass filter (BPF).

15. The mobile communication terminal of any one of claims 8 to 14, wherein the filter comprises a variable band pass filter (BPF) which is capable of varying a filtering band.
